# EUROPÄISCHE PATENTSCHRIFT

(11) **EP 3 564 824 B1**
(45) Veröffentlichungstag und Bekanntmachung des Hinweises auf die Patenterteilung: **20.01.2021**
(21) Anmeldenummer: 19164948.2
(22) Anmeldetag: 25.03.2019
(51) Int. Cl.: G06F 13/40

(54) **SCHNITTSTELLENANORDNUNG AUF EINER SYSTEMPLATINE UND COMPUTERSYSTEM**
INTERFACE ARRANGEMENT ON A SYSTEM BOARD AND COMPUTER SYSTEM
DISPOSITIF D'INTERFACE SUR UNE CARTE SYSTÈME ET SYSTÈME INFORMATIQUE

(30) Priorität: 02.05.2018 DE 202018102439 U
(43) Veröffentlichungstag der Anmeldung: 06.11.2019
(73) Patentinhaber: Fujitsu Technology Solutions Intellectual Property GmbH, 80807 München (DE)
(72) Erfinder: Maier, Andreas, 80807 München (DE)
(74) Vertreter: Epping - Hermann - Fischer

(56) Entgegenhaltungen:
- DE-B3-102011 113 068
- US-A1- 2004 196 062
- US-A1- 2007 032 100

## Beschreibung

Die vorliegende Erfindung betrifft eine Schnittstellenanordnung auf einer Systemplatine und ein Computersystem umfassend wenigstens eine Systemplatine mit wenigstens einer derartigen Schnittstellenanordnung.

Schnittstellen auf Systemplatinen sind heutzutage weit verbreitet. Beispielsweise Motherboards für Computersysteme weisen gewöhnlich Schnittstellen auf, um eine Kommunikation zwischen Peripheriegeräten mit den Computersystemen über die Schnittstellen zu ermöglichen.

Je nach Bedarf werden heutzutage unterschiedliche Standards, wie beispielsweise bei USB-Schnittstellen USB 3.0 gemäß Universal Serial Bus 3.0 Specification, Revision 1.0, vom 12. November 2008, USB 3.1 Generation 1 gemäß Universal Serial Bus 3.1 Specification, Revision 1.0, vom 26. Juli 2013, USB 3.1 Generation 2 gemäß Universal Serial Bus 3.1 Specification, Revision 1.0, vom 26. Juli 2013, und USB 3.2 gemäß Universal Serial Bus 3.2 Specification, Revision 1.0, vom 22. September 2017, in Computersystemen verwendet. Unterschiedliche Standards können sich beispielsweise in einer Datenübertragungsrate unterscheiden. Dementsprechend weisen auch die Systemplatinen Unterschiede auf, in Abhängigkeit davon, welcher Standard an einer Schnittstelle unterstützt werden soll. Das Dokument US2004196062 schlägt beispielsweise eine Bestückungsoption auf einer Leiterplatte mit einem seriellen Kondensator- oder Widerstandsabschluss für differentielle Signalübertragung vor.

Aufgabe der vorliegenden Erfindung ist es, einen Produktionssowie Kostenaufwand bei der Herstellung derartiger Systemplatinen zu verringern.

Gemäß einem ersten Aspekt wird die oben genannte Aufgabe durch eine Schnittstellenanordnung auf einer Systemplatine gelöst. Die Schnittstellenanordnung umfasst wenigstens zwei Datenleitungen für eine differenzielle Signalübertragung über die Schnittstellenanordnung. Die Schnittstellenanordnung umfasst ferner wenigstens einen ersten Bestückungsplatz für wenigstens einen ersten Verbinder, wenigstens einen zweiten Bestückungsplatz für wenigstens einen zweiten Verbinder und einen dritten Bestückungsplatz für einen integrierten Schaltkreis. An dem wenigstens einen ersten Bestückungsplatz werden die Datenleitungen in einen ersten Pfad und einen zweiten Pfad aufteilt. An dem wenigstens einen zweiten Bestückungsplatz werden der zweite Pfad und der erste Pfad zusammengeführt. Der dritte Bestückungsplatz für den integrierten Schaltkreis ist in dem ersten Pfad angeordnet. Der wenigstens eine erste Verbinder und der wenigstens eine zweite Verbinder ist an dem wenigstens einen ersten bzw. wenigstens einen zweiten Bestückungsplatz jeweils in einer ersten oder einer zweiten Position anbringbar, sodass Signale in den Datenleitungen über den ersten Pfad oder über den zweiten Pfad laufen.

Ein Vorteil hierbei ist es, dass eine Schnittstelle auf einer Systemplatine ohne großen Aufwand entsprechend einem von der Schnittstelle zu unterstützenden Standard angepasst werden kann. Standards mit einer höheren Datenübertragungsrate verwenden beispielsweise einen zusätzlichen integrierten Schaltkreis, um Signalverluste in den Datenleitungen auszugleichen. Dies ist beispielsweise bei dem Standard USB 3.1 Generation 2 der Fall, mit dem Datenübertragungsraten von bis zu 10 Gigabit pro Sekunde (Gbit/s) erreicht werden. Beispielsweise bei dem Standard USB 3.1 Generation 1 hingegen werden lediglich Datenübertragungsraten von bis zu 5 Gbit/s erreicht, sodass auf einen derartigen integrierten Schaltkreis verzichtet werden kann. Ähnliches gilt beispielsweise für unterschiedliche Spezifikationen bei Thunderbolt-Schnittstellen, PCI Express-Schnittstellen, Serial ATA (Serial AT Attachment)-Schnittstellen und ähnlichen Schnittstellen mit vergleichbar hohen oder höheren Datenübertragungsraten. Die hierin beschriebene Schnittstellenanordnung kann wahlweise mit einem derartigen integrierten Schaltkreis bestückt werden. In Abhängigkeit davon, ob ein derartiger integrierter Schaltkreis in der Schnittstellenanordnung verwendet wird oder nicht, können Signale in den Datenleitungen der Schnittstellenanordnung über den ersten Pfad oder den zweiten Pfad geleitet werden. Somit kann ein einheitliches Systemplatinenmodell verwendet werden, unabhängig davon, welcher Standard von einer Schnittstelle der Systemplatine unterstützt werden soll. Dies senkt sowohl einen Produktions- als auch einen Kostenaufwand bei einer Herstellung solcher Systemplatinen.

In wenigstens einer Ausgestaltung umfasst der wenigstens eine erste Verbinder und/oder der wenigstens eine zweite Verbinder zwei Null-Ohm-Widerstände, die zu einem Chip-Widerstandsnetzwerk zusammengefasst sind.

Die Verwendung eines Chip-Widerstandsnetzwerks (engl.: Chip Resistor Array) ist vorteilhaft, da diese sowohl manuell als auch maschinell leicht handzuhaben sind, sodass eine Bestückung der Systemplatine mit dem Verbinder vereinfacht wird.

In wenigstens einer Ausgestaltung der Erfindung umfasst der wenigstens eine erste Verbinder und/oder der wenigstens eine zweite Verbinder zwei Kondensatoren.

Kondensatoren werden gewöhnlich auf Systemplatinen in Schaltungen von Schnittstellenanordnungen verwendet, beispielsweise für eine Gleichspannungsentkopplung der differentiellen Datenleitungen. Werden für den wenigstens einen ersten und/oder den wenigstens einen zweiten Verbinder entsprechende Kondensatoren verwendet, können zusätzliche Komponenten in der Schnittstellenanordnung eingespart werden. Die beiden Kondensatoren sind beispielsweise einzeln auf dem wenigstens einen ersten bzw. wenigstens einen zweiten Bestückungsplatz anbringbar oder sie sind in Chip-Bauform zusammengefasst.

In wenigstens einer Ausgestaltung der Erfindung umfasst der wenigstens eine erste Bestückungsplatz und/oder der wenigstens eine zweite Bestückungsplatz sechs Pads, wobei die sechs Pads in zwei zueinander parallel verlaufenden Reihen von jeweils drei Pads angeordnet sind. Zwei mittige Pads sind einem gemeinsamen Teil der Datenleitungen, zwei Pads an einer ersten Seite den Datenleitungen des ersten Pfads und zwei Pads an einer zweiten Seite den Datenleitungen des zweiten Pfads zugeordnet.

Auf diese Weise ist es möglich, mit dem ersten bzw. dem zweiten Verbinder den gemeinsamen Teil der Datenleitungen entweder mit dem ersten Pfad oder dem zweiten Pfad zu verbinden, je nachdem, ob sie in einer ersten oder einer zweiten Position angebracht sind. Ein Vorteil hierbei ist es, dass an dem wenigstens einen ersten bzw. dem wenigstens einen zweiten Bestückungsplatz keine Leitungsenden überstehen und keine Kreuzungen oder Verzweigungen in den Leitungen vorkommen. Die Verbinder stellen einen kontinuierlichen, unverzweigten Übergang zwischen dem gemeinsamen Teil der Datenleitungen und den Datenleitungen des ersten bzw. des zweiten Pfads her. So wird die Gefahr des Auftretens einer Totalreflexion, beispielsweise an offenen Leitungsenden, gemindert.

Gemäß einem zweiten Aspekt wird die oben genannte Aufgabe durch ein Computersystem umfassend wenigstens eine Systemplatine mit wenigstens einer Schnittstellenanordnung gemäß dem ersten Aspekt gelöst.

Vorteile des zweiten Aspekts entsprechen im Wesentlichen den Vorteilen des ersten Aspekts.

Weitere vorteilhafte Ausgestaltungen sind in den angehängten Ansprüchen sowie der nachfolgenden Beschreibung von Ausführungsbeispielen beschrieben. Die Ausführungsbeispiele werden anhand der angehängten Figuren beschrieben. In den Figuren werden für Elemente mit im Wesentlichen gleicher Funktion gleiche Bezugszeichen verwendet, diese Elemente müssen jedoch nicht in allen Einzelheiten identisch sein.

In den Figuren zeigen:
- Figur 1: eine perspektivische Darstellung eines Computersystems mit einer Systemplatine, auf der eine USB-Schnittstelle angeordnet ist,
- Figur 2: eine Teilansicht einer Systemplatine mit einer USB-Schnittstelle gemäß einer Ausgestaltung der Erfindung in einer ersten Bestückungsoption,
- Figur 3: einen Ausschnitt der Teilansicht der Systemplatine gemäß Figur 2,
- Figur 4: eine Teilansicht der Systemplatine mit der USB-Schnittstelle gemäß Figur 2 in einer zweiten Bestückungsoption, und
- Figur 5: einen Ausschnitt der Teilansicht der Systemplatine gemäß Figur 4.

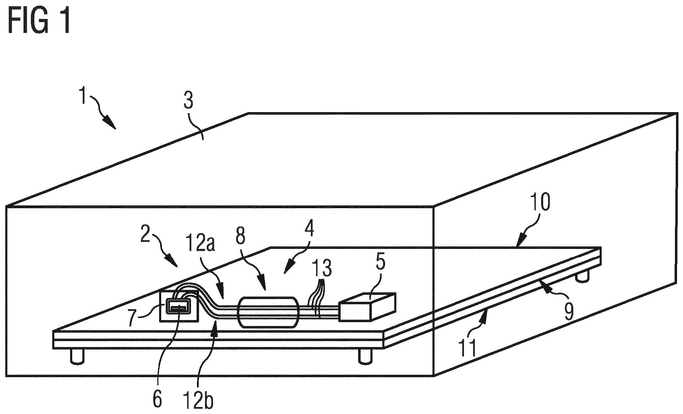

Figur 1 zeigt eine perspektivische Darstellung eines Computersystems 1 mit einer Systemplatine 2. Die Systemplatine 2 ist in einem Gehäuse 3 des Computersystems 1 angeordnet. In diesem Ausführungsbeispiel ist die Systemplatine 2 ein Motherboard des Computersystems 1. In einer alternativen Ausgestaltung ist die Systemplatine beispielsweise ein USB-Modul, welches mit einer Systemplatine eines Computersystems verbunden wird, oder eine PCIe-Karte. Das Computersystem 1 ist in diesem Ausführungsbeispiel ein Desktop-Computer. In einer alternativen Ausgestaltung ist das Computersystem ein Laptop, ein Server, ein Tablet-Computer oder ein sonstiges elektrisches Gerät.

Die Systemplatine 2 weist eine USB-Schnittstelle 4 auf, über die ein Datenaustausch zwischen dem Computersystem 1 und einem hier nicht gezeigten Peripheriegerät ermöglicht wird. Die USB-Schnittstelle 4 umfasst einen USB-Host-Controller 5 und eine USB-Buchse 6. Die USB-Buchse 6 ist beispielsweise eine USB-Typ-A oder USB-Typ-C Buchse und stellt einen physikalischen Anschluss für Peripheriegeräte an die USB-Schnittstelle 4 des Computersystems 1 dar. Die USB-Buchse 6 ist an einem Panel 7 des Gehäuses 3 befestigt. In einer alternativen Ausgestaltung ist die USB-Schnittstelle 4 dazu eingerichtet, einen internen USB-Anschluss in dem Computersystem 1 bereitzustellen, über den weitere, hier nicht gezeigte Komponenten des Computersystems 1 an die Systemplatine 2 angeschlossen werden können. Zum Zweck einer einfachen Beschreibung ist hier lediglich eine USB-Buchse 6 gezeigt. Das Computersystem 1 kann jedoch selbstverständlich auch weitere derartige USB-Buchsen aufweisen.

Der USB-Host-Controller 5 ist unter anderem dazu eingerichtet, eine Signalübertragung über die USB-Schnittstelle 4 zu steuern und stellt einen Master in dem Bussystem der USB-Schnittstelle 4 dar. Der USB-Host-Controller 5 unterstützt in diesem Ausführungsbeispiel entweder eine Signalübertragung über die USB-Schnittstelle 4 gemäß dem Standard USB 3.1 Generation 1 oder gemäß dem Standard USB 3.1 Generation 2. Bezüglich einem von der USB-Schnittstelle 4 zu unterstützenden Standard wird der USB-Host-Controller 5 entsprechend konfiguriert. Alternativ ist es auch möglich, dass je nachdem, welcher USB-Standard an der USB-Schnittstelle 4 unterstützt werden soll, die Systemplatine 2 mit unterschiedlichen USB-Host-Controllern bestückt wird, die entweder nur eine Signalübertragung gemäß dem Standard USB 3.1 Generation 1 oder eine Signalübertragung gemäß dem Standard USB 3.1 Generation 1 und gemäß dem Standard USB 3.1 Generation 2 unterstützen. Letzterer kann wahlweise so konfiguriert werden, dass er beide Standards oder nur einen der beiden Standards unterstützt.

Des Weiteren umfasst die USB-Schnittstelle 4 eine Schnittstellenschaltung 8. Die Schnittstellenschaltung 8 stellt eine elektrische Verbindung zwischen dem USB-Host-Controller 5 und der USB-Buchse 6 her. Die Schnittstellenschaltung 8 umfasst hierzu einen ersten Signalpfad 12a und einen zweiten Signalpfad 12b, die jeweils zwei Datenleitungen 13 aufweisen. Die Datenleitungen 13 sind dazu eingerichtet, differenzielle Datensignale über die USB-Schnittstelle 4 zu senden und zu empfangen. Der erste Signalpfad 12a wird hierbei für das Senden von Daten an ein an die Buchse 6 angeschlossenes Peripheriegerät, der zweite Signalpfad 12b für das Empfangen von Daten von dem Peripheriegerät verwendet. Die Signalpfade 12a, 12b ermöglichen somit eine full-duplex Kommunikation über die USB-Schnittstelle 4.

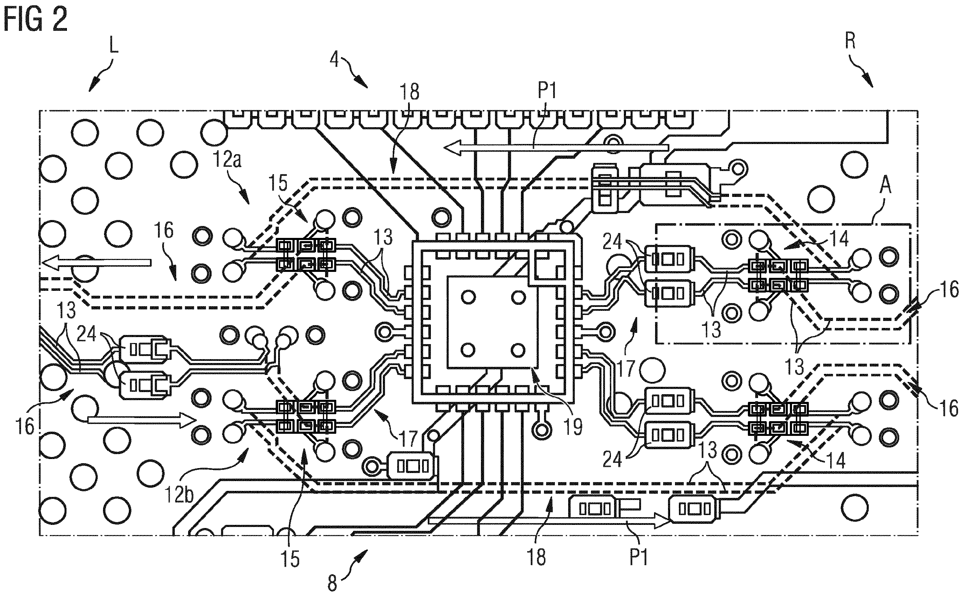

In dieser Ausgestaltung ist die Systemplatine 2 eine mehrlagige Systemplatine, sodass die Datenleitungen 13 teilweise an einer Oberseite 10 der Systemplatine 2, an der ein überwiegender Teil von auf der Systemplatine 2 angebrachten, hier nicht gezeigten Komponenten angeordnet ist, und teilweise an einer der Oberseite 10 abgewandten Unterseite 11 oder einer Zwischenlage 9 der Systemplatine 2 verlaufen. Die Datenleitungen 13 werden detailliert anhand der Figuren 2 bis 5 beschrieben.

Die Systemplatine 2 ist dazu eingerichtet, gemäß einer ersten Bestückungsoption BO1 oder gemäß einer zweiten Bestückungsoption BO2 bestückt zu werden. Die erste Bestückungsoption BO1 ist dadurch gekennzeichnet, dass ein USB-Host-Controller 5 auf der Systemplatine 2 angebracht ist, der eine Signalübertragung über die USB-Schnittstelle 4 gemäß dem Standard USB 3.1 Generation 1 unterstützt. Die zweite Bestückungsoption BO2 ist dadurch gekennzeichnet, dass der USB-Host-Controller 5 eine Signalübertragung über die USB-Schnittstelle 4 gemäß dem Standard USB 3.1 Generation 2 unterstützt.

Die Schnittstellenschaltung 8 sowie weitere Details der ersten Bestückungsoption BO1 bzw. zweiten Bestückungsoption BO2 der Systemplatine 2 werden ebenfalls anhand der Figuren 2 bis 5 genauer beschrieben.

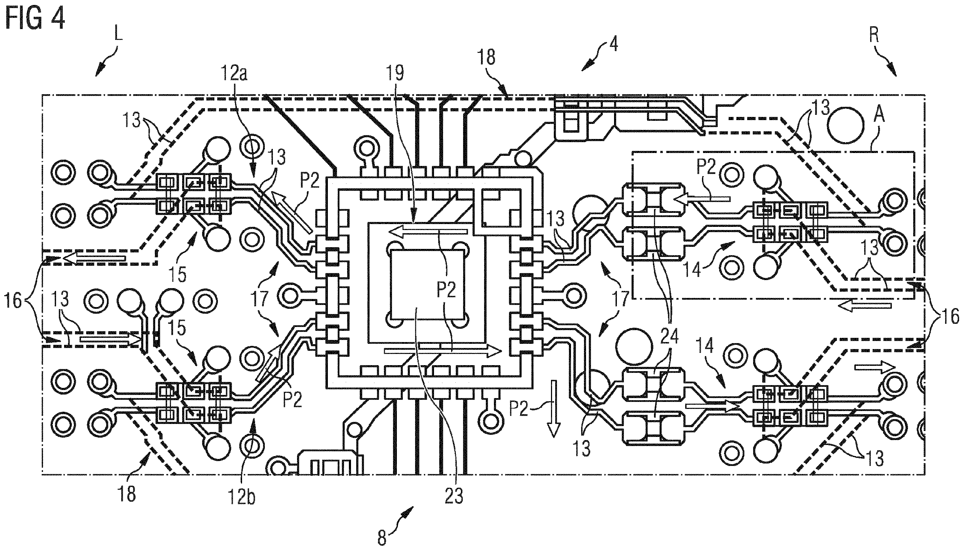

Figur 2 zeigt eine Teilansicht einer Systemplatine 2 mit einer USB-Schnittstelle 4 gemäß einer Ausgestaltung der Erfindung in einer ersten Bestückungsoption BO1. Figur 4 zeigt eine Teilansicht der Systemplatine 2 gemäß Figur 2 gemäß einer zweiten Bestückungsoption BO2. Die Figuren 2 und 4 zeigen insbesondere Schnittstellenschaltungen 8, wie sie beispielsweise in der USB-Schnittstelle 4 gemäß Figur 1 verwendet werden. Das heißt, gemäß der ersten Bestückungsoption BO1 ist auf der Systemplatine 2 gemäß Figur 1 der USB-Host-Controller 5 derart konfiguriert, dass er eine Signalübertragung über die USB-Schnittstelle 4 gemäß dem Standard USB 3.1 Generation 1 unterstützt und gemäß der zweiten Bestückungsoption BO2 ist auf der Systemplatine 2 gemäß Figur 1 der USB-Host-Controller 5 derart konfiguriert, dass er eine Signalübertragung über die USB-Schnittstelle 4 gemäß dem Standard USB 3.1 Generation 2 unterstützt.

Die Schnittstellenschaltung 8, wie in den Figuren 2 und 4 gezeigt, umfasst zwei Signalpfade 12a, 12b, die jeweils zwei parallel verlaufende Datenleitungen 13 aufweisen. Die jeweils parallel verlaufenden Datenleitungen 13 werden für eine differenzielle Signalübertragung über die USB-Schnittstelle 4 verwendet. Der erste Signalpfad 12a und der zweite Signalpfad 12b ermöglichen eine full-duplex Kommunikation über die USB-Schnittstelle 4, wie mit Bezug auf Figur 1 beschrieben.

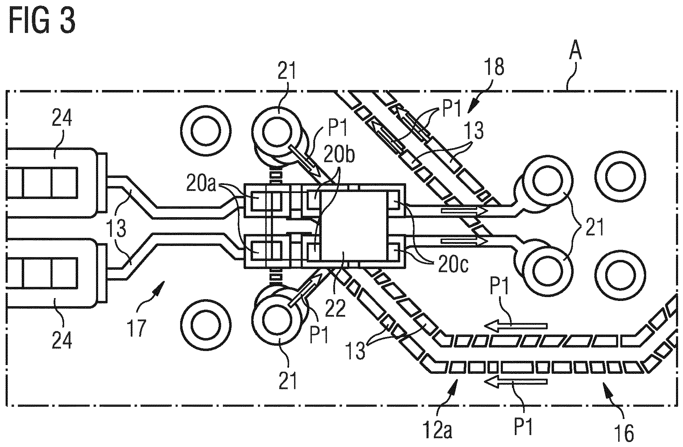

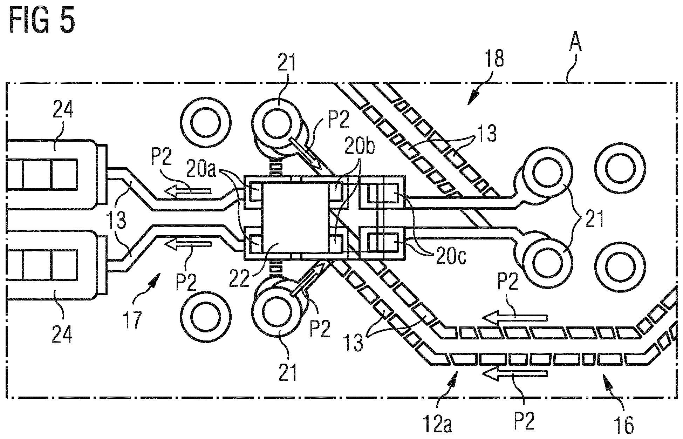

Die Datenleitungen 13 jedes Signalpfads 12a, 12b weisen jeweils einen gemeinsamen Teil 16, einen ersten Pfad 17 und einen zweiten Pfad 18 auf. In beiden Signalpfaden 12a, 12b sind jeweils ein erster Bestückungsplatz 14 und ein zweiter Bestückungsplatz 15 für Widerstandsnetzwerke angeordnet. An den ersten bzw. zweiten Bestückungsplätzen 14, 15 werden die gemeinsamen Teile 16 der Datenleitungen 13 in die ersten Pfade 17 und zweiten Pfade 18 aufgeteilt bzw. zusammengeführt. Die ersten bzw. zweiten Bestückungsplätze 14, 15 werden detailliert anhand der Figuren 3 und 5 beschrieben.

An eine linke Seite L der in den Figuren 2 und 4 gezeigten Schnittstellenschaltung 8 ist eine in diesen Figuren nicht gezeigte USB-Buchse, wie beispielsweise die USB-Buchse 6 gemäß Figur 1, angeschlossen. Eine rechte Seite R der in den Figuren 2 und 4 gezeigten Schnittstellenschaltung 8 entspricht einer Host-Seite der USB-Schnittstelle 4.

Die Schnittstellenschaltung 8 umfasst des Weiteren einen dritten Bestückungsplatz 19 für einen Re-Timer oder einen Re-Driver. Gemäß der ersten Bestückungsoption BO1, gezeigt in Figur 2, ist kein Re-Timer oder Re-Driver an dem dritten Bestückungsplatz 19 angebracht. Gemäß der zweiten Bestückungsoption BO2, gezeigt in Figur 4, ist an dem dritten Bestückungsplatz 19 ein Re-Timer 23 angebracht. Alle Bestückungsplätze 14, 15, 19 weisen Lötstellen für oberflächenmontierte Bauteile, sogenannte Pads, auf.

Gemäß der ersten Bestückungsoption BO1, das heißt wenn kein Re-Timer oder Re-Driver an dem dritten Bestückungsplatz 19 angebracht ist, werden die gemeinsamen Teile 16 der Datenleitungen 13 mit den Datenleitungen 13 der zweiten Pfade 18 an dem ersten bzw. dem zweiten Bestückungsplatz 14, 15 elektrisch verbunden, sodass Datensignale über die zweiten Pfade 18 entlang der Pfeile P1 an dem dritten Bestückungsplatz 19 vorbeigeleitet werden. Ein Beispiel für eine derartige elektrische Verbindung wird detailliert anhand der Figur 3 beschrieben.

Gemäß der zweiten Bestückungsoption BO2, das heißt wenn ein Re-Timer 23 an dem dritten Bestückungsplatz 19 angebracht ist, werden die gemeinsamen Teile 16 der Datenleitungen 13 mit den Datenleitungen 13 der ersten Pfade 17 an dem ersten bzw. dem zweiten Bestückungsplatz 14, 15 elektrisch verbunden, sodass Datensignale über die ersten Pfade 17 und somit auch über den Re-Timer 23 an dem dritten Bestückungsplatz 19 entlang der Pfeile P2 geleitet werden. Ein Beispiel für eine derartige Verbindung wird detailliert anhand der Figur 5 beschrieben.

Figur 3 zeigt einen Ausschnitt der Teilansicht der USB-Schnittstelle 4 gemäß Figur 2. Der in Figur 3 gezeigte Bereich der USB-Schnittstelle 4 ist in der Figur 2 als Bereich A markiert. Figur 3 zeigt diesen Ausschnitt gemäß der ersten Bestückungsoption BO1. Figur 5 zeigt den gleichen Bereich A, allerdings gemäß Figur 4 gemäß der zweiten Bestückungsoption BO2.

Der Bereich A umfasst einen der ersten Bestückungsplätze 14, einen Teil des gemeinsamen Teils 16 der Datenleitungen 13, sowie einen Teil eines der ersten Pfade 17 und einen Teil eines der zweiten Pfade 18.

Der erste Bestückungsplatz 14 besteht aus insgesamt sechs Pads 20a, b, c, die in zwei parallelen Reihen zu je drei Pads 20a, b, c angeordnet sind. Zwei mittlere Pads 20b sind elektrisch mit jeweils einer der Datenleitungen 13 des gemeinsamen Teils 16 fest verbunden. Zwei Pads 20a auf einer ersten Seite der mittleren Pads 20b sind jeweils mit den Datenleitungen 13 des ersten Pfads 17 und zwei weitere Pads 20c an einer zweiten Seite der mittleren Pads 20b sind mit den Datenleitungen 13 des zweiten Pfads 18 elektrisch verbunden. Diese elektrischen Verbindungen der Pads 20a, b, c mit den jeweiligen Datenleitungen 13 sind fester Bestandteil der Systemplatine 2. In der Systemplatine selbst sind die Pads 20a, b, c elektrisch voneinander getrennt.

Die Pads 20a, b, c befinden sich an der Oberseite 10 der Systemplatine 2. Der erste Pfad 17 verläuft ebenfalls an der Oberseite 10 der Systemplatine 2. Der gemeinsame Teil 16 der Datenleitungen 13 und der zweite Pfad 18 verlaufen von den Pads 20b, c nur bis zu in der Systemplatine 2 eingelassenen Vias 21 an der Oberseite 10. Die Vias 21 dienen als Durchkontaktierungen durch die Systemplatine 2, sodass ein Großteil des gemeinsamen Teils 16 der Datenleitungen 13 und des zweiten Pfads 18 auf der Unterseite 11 der Systemplatine 2 verlaufen. Auf diese Weise werden die Datenleitungen 13 so geführt, dass sie die entsprechenden Pads 20a, b, c kontaktieren, ohne einander zu kreuzen oder offene Leitungsenden zu bilden. So werden Totalreflexionen in den Datenleitungen 13 verhindert oder zumindest gemindert. In den Figuren 2 bis 5 sind Datenleitungen 13, die an der Oberseite 10 der Systemplatine 2 verlaufen, mit durchgehenden Linien und Datenleitungen 13, die an der Unterseite 11 der Systemplatine 2 verlaufen, mit gestrichelten Linien gekennzeichnet.

Der erste Bestückungsplatz 14 ist mit einem Null-Ohm-Widerstandsnetzwerk 22 in Chip-Bauform bestückt. Das Null-Ohm-Widerstandsnetzwerk 22 umfasst zwei Null-Ohm-Widerstände, die parallel zueinander angeordnet sind. Das Null-Ohm-Widerstandsnetzwerk 22 weist vier Kontaktpunkte auf, über die das Null-Ohm-Widerstandsnetzwerk 22 mit vier der sechs Pads 20a, b, c des ersten Bestückungsplatzes 14 verlötet ist.

Gemäß der ersten Bestückungsoption BO1 ist das Null-Ohm-Widerstandsnetzwerk 22 mit den Pads 20b und 20c elektrisch verbunden. Dies ist in Figur 3 gezeigt. Jeweils einer der Null-Ohm-Widerstände stellt so eine elektrische Verbindung zwischen jeweils einer Datenleitung 13 des gemeinsamen Teils 16 mit jeweils einer Datenleitung 13 des zweiten Pfads 18 her.

Gemäß der zweiten Bestückungsoption BO2 ist das Null-Ohm-Widerstandsnetzwerk 22 mit den Pads 20a und 20b elektrisch verbunden. Dies ist in Figur 5 gezeigt. Jeweils einer der Null-Ohm-Widerstände stellt so eine elektrische Verbindung zwischen jeweils einer Datenleitung 13 des gemeinsamen Teils 16 mit jeweils einer Datenleitung 13 des ersten Pfads 18 her.

Der weitere erste Bestückungsplatz 14 und die zweiten Bestückungsplätze 15 werden in analoger Weise mit Null-Ohm-Widerstandsnetzwerken 22 bestückt, sodass gemäß der ersten Bestückungsoption BO1 ein durchgängiger Signalpfad über den gemeinsamen Teil 16 und den zweiten Pfad 18 und gemäß der zweiten Bestückungsoption BO2 ein durchgängiger Signalpfad über den gemeinsamen Teil 16 und den ersten Pfad 17 hergestellt wird.

In den Figuren 2 bis 5 sind ferner Kondensatoren 24 in der Schnittstellenschaltung 8 gezeigt. In einer alternativen Ausgestaltung der Erfindung kann eine Anzahl von Bauteilen verringert werden, indem statt der Null-Ohm-Widerstände den Kondensatoren 24 entsprechende Kondensatoren zur elektrischen Kontaktierung der Pads 20a, b, c miteinander verwendet werden. Derartige Kondensatoren können ebenfalls in einem Kondensatornetzwerk zusammengefasst sein, die dann in analoger Weise mit jeweils vier der sechs Pads der ersten bzw. zweiten Bestückungsplätze verlötet werden.

Die hier anhand der Figuren 1 bis 5 beschriebenen Merkmale der USB-Schnittstelle 4 können in analoger Weise ebenfalls für andere Schnittstellen wie beispielsweise Thunderbolt-Schnittstellen, PCI Express-Schnittstellen, Serial ATA (Serial AT Attachment)-Schnittstellen und ähnlichen Schnittstellen mit vergleichbar hohen oder höheren Datenübertragungsraten verwendet werden.

### Bezugszeichenliste

- 1: Computersystem
- 2: Systemplatine
- 3: Gehäuse
- 4: USB-Schnittstelle
- 5: USB-Host-Controller
- 6: USB-Buchse
- 7: Panel
- 8: Schnittstellenschaltung
- 9: Zwischenlage der Systemplatine
- 10: Oberseite der Systemplatine
- 11: Unterseite der Systemplatine
- 12a: erster Signalpfad
- 12b: zweiter Signalpfad
- 13: Datenleitung
- 14: erster Bestückungsplatz
- 15: zweiter Bestückungsplatz
- 16: gemeinsamer Teil
- 17: erster Pfad
- 18: zweiter Pfad
- 19: dritter Bestückungsplatz
- 20a, 20b, 20c: Pad
- 21: Via
- 22: Null-Ohm-Widerstandsnetzwerk
- 23: Re-Timer
- 24: Kondensator

- A: Bereich
- P1, P2: Pfeile
- BO1: erste Bestückungsoption
- BO2: zweite Bestückungsoption
- L: linke Seite
- R: rechte Seite

## Patentansprüche

1. Schnittstellenanordnung auf einer Systemplatine (2), umfassend
- wenigstens zwei Datenleitungen (13) für eine differentielle Signalübertragung über die Schnittstellenanordnung,
- wenigstens einen ersten Bestückungsplatz (14) für wenigstens einen ersten Verbinder und wenigstens einen zweiten Bestückungsplatz (15) für wenigstens einen zweiten Verbinder, und **dadurch gekennzeichnet, dass** die Schnittstellenanordnung weiterhin
- einen dritten Bestückungsplatz (19) für einen integrierten Schaltkreis umfasst, wobei
- an dem wenigstens einen ersten Bestückungsplatz (14) die Datenleitungen (13) in einen ersten Pfad (17) und einen zweiten Pfad (18) aufgeteilt werden,
- an dem wenigstens einen zweiten Bestückungsplatz (15) der zweite Pfad (18) und der erste Pfad (17) zusammengeführt werden,
- der dritte Bestückungsplatz (19) für den integrierten Schaltkreis in dem ersten Pfad (17) angeordnet ist, und
- der wenigstens eine erste Verbinder und der wenigstens eine zweite Verbinder an dem wenigstens einen ersten bzw. wenigstens einen zweiten Bestückungsplatz (14, 15) jeweils in einer ersten oder einer zweiten Position anbringbar sind, sodass Signale in den Datenleitungen (13) über den ersten Pfad (17) oder über den zweiten Pfad (18) laufen.

2. Schnittstellenanordnung gemäß Anspruch 1, ferner umfassend einen Host-Controller, welcher eine Signalübertragung mit einer ersten Datenübertragungsragte oder mit einer zweiten Datenübertragungsrate unterstützt und im Falle einer Unterstützung der ersten Datenübertragungsrate durch den Host-Controller der dritte Bestückungsplatz (19) unbestückt ist und im Falle einer Unterstützung der zweiten Datenübertragungsrate durch den Host-Controller ein integrierter Schaltkreis an dem dritten Bestückungsplatz (19) angebracht ist, wobei die zweite Datenübertragungsrate höher als die erste Datenübertragungsrate ist.

3. Schnittstellenanordnung gemäß Anspruch 2, wobei die Schnittstellenanordnung eine USB-Schnittstellenanordnung ist und der Host-Controller ein USB-Host-Controller (5) ist, der die Signalübertragung mit der ersten Datenübertragungsrate gemäß dem Standard USB 3.1 Gen. 1 und die Signalübertragung mit der zweiten Datenübertragungsrate gemäß dem Standard USB 3.1 Gen. 2 unterstützt und im Falle einer Unterstützung des Standards USB 3.1 Gen. 1 durch den USB-Host-Controller (5) der dritte Bestückungsplatz (19) unbestückt ist und im Falle einer Unterstützung des Standards USB 3.1 Gen. 2 durch den USB-Host-Controller (5) ein integrierter Schaltkreis an dem dritten Bestückungsplatz (19) angebracht ist.

4. Schnittstellenanordnung gemäß einem der Ansprüche 1 oder 3, wobei der wenigstens eine erste Verbinder und/oder der wenigstens eine zweite Verbinder wenigstens ein oberflächenmontiertes Bauelement umfasst.

5. Schnittstellenanordnung gemäß einem der Ansprüche 1 bis 4, wobei der wenigstens eine erste Verbinder und/oder der wenigstens eine zweite Verbinder zwei Null-Ohm-Widerstände umfasst, die zu einem Chip-Widerstand-Netzwerk zusammengefasst sind.

6. Schnittstellenanordnung gemäß einem der Ansprüche 1 bis 4, wobei der wenigstens eine erste Verbinder und/oder der wenigstens eine zweite Verbinder zwei Kondensatoren umfasst.

7. Schnittstellenanordnung gemäß einem der Ansprüche 1 bis 6, wobei der wenigstens eine erste Verbinder und der wenigstens eine zweite Verbinder in der ersten oder der zweiten Position auf die Systemplatine (2) aufgelötet sind, in Abhängigkeit davon, ob an dem dritten Bestückungsplatz (19) ein integrierter Schaltkreis angebracht ist oder ob der dritte Bestückungsplatz (19) unbestückt ist.

8. Schnittstellenanordnung gemäß einem der Ansprüche 1 bis 7, wobei die Systemplatine (2), auf der die Schnittstellenanordnung angeordnet ist, als mehrlagige Systemplatine (2) ausgestaltet ist und der erste Pfad (17) an einer Oberseite (10) der Systemplatine (2) verläuft, an der die Systemplatine (2) mit Bauteilen bestückt ist, und der zweite Pfad (18) und ein gemeinsamer Teil (16) der Datenleitungen (13) zumindest überwiegend an einer der Oberseite (10) abgewandten Unterseite (11) der Systemplatine (2) oder entlang einer Zwischenlage (9) der Systemplatine (2) verlaufen.

9. Schnittstellenanordnung gemäß einem der Ansprüche 1 bis 8, wobei der wenigstens eine erste Bestückungsplatz (14) und/oder der wenigstens eine zweite Bestückungsplatz (15) sechs Pads (20a, 20b, 20c) umfassen, wobei die sechs Pads (20a, 20b, 20c) in zwei zueinander parallel verlaufenden Reihen von jeweils drei Pads (20a, 20b, 20c) angeordnet sind, von denen zwei mittige Pads (20b) einem gemeinsamen Teil (16) der Datenleitungen (13), zwei Pads (20a) an einer ersten Seite den Datenleitungen (13) des ersten Pfads (17) und zwei Pads (20c) an einer zweiten Seite den Datenleitungen (13) des zweiten Pfads (18) zugeordnet sind.

10. Schnittstellenanordnung gemäß einem der Ansprüche 1 bis 9, wobei der integrierte Schaltkreis ein Re-Timer (23) oder ein Re-Driver ist.

11. Computersystem (1) umfassend wenigstens eine Systemplatine (2) mit wenigstens einer Schnittstellenanordnung gemäß einem der Ansprüche 1 bis 10.

12. Computersystem (1) gemäß Anspruch 11, wobei die wenigstens eine Schnittstellenanordnung ferner wenigstens eine Buchse zum Anschließen eines Peripheriegeräts an das Computersystem (1) umfasst.

## Claims

1. Interface arrangement on a system board (2), comprising
- at least two data lines (13) for a differential signal transmission via the interface arrangement,
- at least one first mounting location (14) for at least one first connector and at least one second mounting location (15) for at least one second connector, and **characterized in that** the interface arrangement further comprises
- a third mounting location (19) for an integrated circuit, wherein
- at the at least one first mounting location (14) the data lines (13) are divided into a first path (17) and a second path (18),
- at the at least one second mounting location (15) the second path (18) and the first path (17) are joined,
- the third mounting location (19) for the integrated circuit is arranged in the first path (17), and
- the at least one first connector and the at least one second connector can be mounted at the at least one first and at least one second mounting location (14, 15) in a first or a second position respectively, so that signals in the data lines (13) run via the first path (17) or via the second path (18).

2. Interface arrangement according to claim 1, further comprising a host controller, which supports a signal transmission with a first data transmission rate or with a second data transmission rate, and in the case of support of the first data transmission rate by the host controller, the third mounting location (19) is unpopulated, and in the case of support of the second data transmission rate by the host controller, an integrated circuit is fitted at the third mounting location (19), wherein the second data transmission rate is higher than the first data transmission rate.

3. Interface arrangement according to claim 2, wherein the interface arrangement is a USB interface arrangement and the host controller is a USB host controller (5), which supports the signal transmission at the first data transmission rate according to the standard USB 3.1 Gen. 1 and the signal transmission at the second data transmission rate according to the standard USB 3.1 Gen. 2, and in the case of support of the standard USB 3.1 Gen. 1 by the USB host controller (5), the third mounting location (19) is unpopulated and in the case of support of the standard USB 3.1 Gen. 2 by the USB host controller (5), an integrated circuit is fitted at the third mounting location (19).

4. Interface arrangement according to one of claims 1 or 3, wherein the at least one first connector and/or the at least one second connector comprises at least one surface-mounted component.

5. Interface arrangement according to any one of claims 1 to 4, wherein the at least one first connector and/or the at least one second connector comprises two zero-ohm resistors, which are combined to give a chip resistor array.

6. Interface arrangement according to any one of claims 1 to 4, wherein the at least one first connector and/or the at least one second connector comprises two capacitors.

7. Interface arrangement according to any one of claims 1 to 6, wherein the at least one first connector and the at least one second connector are soldered in the first or the second position on the system board (2) depending on whether an integrated circuit is fitted at the third mounting location (19) or whether the third mounting location (19) is unpopulated.

8. Interface arrangement according to any one of claims 1 to 7, wherein the system board (2), on which the interface arrangement is arranged, is configured as a multilayer system board (2) and the first path (17) runs on an upper side (10) of the system board (2), on which side the system board is fitted with components, and the second path (18) and a common portion (16) of the data lines (13) run at least predominantly on a lower side (11) of the system board (2) facing away from the upper side (10) or along an intermediate layer (9) of the system board (2).

9. Interface arrangement according to any one of claims 1 to 8, wherein the at least one first mounting location (14) and/or the at least one second mounting location (15) comprise six pads (20a, 20b, 20c), wherein the six pads (20a, 20b, 20c) are arranged in two rows of three pads each (20a, 20b, 20c) running parallel to one another, of which two central pads (20b) are associated with a common portion (16) of the data lines (13), two pads (20a) on a first side are associated with the data lines (13) of the first path (17) and two pads (20c) on a second side are associated with the data lines (13) of the second path (18).

10. Interface arrangement according to any one of claims 1 to 9, wherein the integrated circuit is a retimer (23) or a redriver.

11. Computer system (1) comprising at least one system board (2) with at least one interface arrangement according to any one of claims 1 to 10.

12. Computer system (1) according to claim 11, wherein the at least one interface arrangement further comprises at least one port for connecting a peripheral device to the computer system (1).

## Revendications

1. Dispositif d'interface sur une carte système (2), comprenant
- au moins deux lignes de données (13) pour une transmission de signal différentielle via le dispositif d'interface,
- au moins un premier emplacement d'équipement (14) pour au moins un premier connecteur et au moins un deuxième emplacement d'équipement (15) pour au moins un deuxième connecteur, et **caractérisé en ce que** le dispositif d'interface comprend en outre
- un troisième emplacement d'équipement (19) pour un circuit de commutation intégré,
sachant que
- à l'au moins un premier emplacement d'équipement (14), les lignes de données (13) sont réparties en un premier chemin (17) et un deuxième chemin (18),
- à l'au moins un deuxième emplacement d'équipement (15), le deuxième chemin (18) et le premier chemin (17) sont réunis,
- le troisième emplacement d'équipement (19) pour le circuit de commutation intégré est disposé dans le premier chemin (17), et
- l'au moins un premier connecteur et l'au moins un deuxième connecteur à l'au moins un premier et respectivement l'au moins un deuxième emplacement d'équipement (14, 15) peuvent être placés respectivement dans une première ou une deuxième position de sorte que des signaux dans les lignes de données (13) passent par le premier chemin (17) ou par le deuxième chemin (18).

2. Dispositif d'interface selon la revendication 1, comprenant en outre un dispositif de commande hôte, lequel prend en charge une transmission de signal à un premier débit de transmission de données ou à un deuxième débit de transmission de données et le troisième emplacement d'équipement (19) est non équipé en cas de prise en charge du premier débit de transmission de données par le dispositif de commande hôte et un circuit de commutation intégré est placé au troisième emplacement d'équipement (19) en cas de prise en charge du deuxième débit de transmission de données par le dispositif de commande hôte, sachant que le deuxième débit de transmission de données est plus élevé que le premier débit de transmission de données.

3. Dispositif d'interface selon la revendication 2, sachant que le dispositif d'interface est un dispositif d'interface USB et le dispositif de commande hôte est un dispositif de commande hôte USB (5) qui prend en charge la transmission de signal au premier débit de transmission de données conformément à la norme USB 3.1 Gen. 1 et la transmission de signal au deuxième débit de transmission de données conformément à la norme USB 3.1 Gen. 2 et le troisième emplacement d'équipement (19) est non équipé en cas de prise en charge de la norme USB 3.1 Gen. 1 par le dispositif de commande hôte USB (5) et un circuit de commutation intégré est placé au troisième emplacement d'équipement (19) en cas de prise en charge de la norme USB 3.1 Gen. 2 par le dispositif de commande hôte USB (5).

4. Dispositif d'interface selon l'une des revendications 1 ou 3, sachant que l'au moins un premier connecteur et/ou l'au moins un deuxième connecteur comprennent au moins un composant monté en surface.

5. Dispositif d'interface selon l'une des revendications 1 à 4, sachant que l'au moins un premier connecteur et/ou l'au moins un deuxième connecteur comprennent deux résistances zéro ohm qui sont regroupées en un réseau de résistances de puce.

6. Dispositif d'interface selon l'une des revendications 1 à 4, sachant que l'au moins un premier connecteur et/ou l'au moins un deuxième connecteur comprennent deux condensateurs.

7. Dispositif d'interface selon l'une des revendications 1 à 6, sachant que l'au moins un premier connecteur et l'au moins un deuxième connecteur sont brasés sur la carte système (2) dans la première ou la deuxième position selon qu'un circuit de commutation intégré est placé au troisième emplacement d'équipement (19) ou que le troisième emplacement d'équipement (19) est non équipé.

8. Dispositif d'interface selon l'une des revendications 1 à 7, sachant que la carte système (2) sur laquelle le dispositif d'interface est disposé est constituée comme carte système (2) multicouche et le premier chemin (17) passe au niveau d'un côté supérieur (2) de la carte système (2) au niveau duquel la carte système (2) est équipée en composants, et le deuxième chemin (18) et une partie commune (16) des lignes de données (13) passent au moins essentiellement au niveau d'un côté inférieur (11) opposé au côté supérieur (10) de la carte système (2) ou le long d'une couche intermédiaire (9) de la carte système (2).

9. Dispositif d'interface selon l'une des revendications 1 à 8, sachant que l'au moins un premier emplacement d'équipement (14) et/ou l'au moins un deuxième emplacement d'équipement (15) comprennent six pastilles (20a, 20b, 20c), sachant que les six pastilles (20a, 20b, 20c) sont disposées en deux rangées parallèles l'une à l'autre de respectivement trois pastilles (20a, 20b, 20c) dont deux pastilles médianes (20b) sont associées à une partie commune (16) des lignes de données (13), deux pastilles (20a) sont associées à un premier côté des lignes de données (13) du premier chemin (17) et deux pastilles (20c) sont associées à un deuxième côté des lignes de données (13) du deuxième chemin (18).

10. Dispositif d'interface selon l'une des revendications 1 à 9, sachant que le circuit de commutation intégré est un Re-Timer (23) ou un Re-Driver.

11. Système informatique (1) comprenant au moins une carte système (2) pourvue d'au moins un dispositif d'interface selon l'une des revendications 1 à 10.

12. Système informatique (1) selon la revendication 11, sachant que l'au moins un dispositif d'interface comprend en outre au moins un connecteur pour le raccordement d'un périphérique au système informatique (1).
